# EUROPEAN PATENT SPECIFICATION

(11) **EP 2 143 830 B1**
(45) Date of publication and mention of the grant of the patent: **28.01.2015**
(21) Application number: 08739859.0
(22) Date of filing: 04.04.2008
(51) Int. Cl.: C30B 15/10

(54) **METHOD FOR PROTECTING CARBONACEOUS CRUCIBLE, PROTECTIVE SHEET AND SINGLE CRYSTAL PULLING APPARATUS**
VERFAHREN ZUM SCHUTZ EINES KOHLENSTOFFHALTIGEN TIEGELS, SCHUTZFOLIEN UND EINKRISTALLZIEHVORRICHTUNG
PROCÉDÉ DE PROTECTION D'UN CREUSET CARBONÉ, FEUILLE DE PROTECTION ET DISPOSITIF DE TIRAGE DE MONOCRISTAL

(30) Priority: 06.04.2007 JP 2007100472
(43) Date of publication of application: 13.01.2010
(73) Proprietor: TOYO TANSO CO., LTD., Osaka-shi, Osaka 555-0011 (JP)
(72) Inventor: HIROSE, Yoshiaki, Mitoyo-shi Kagawa 769-1102 (JP); YUKI, Tetsuya, Mitoyo-shi Kagawa 769-1102 (JP)
(74) Representative: Glawe, Delfs, Moll
(86) International application number: PCT/JP2008/056753
(87) International publication number: WO 2008/126779

(56) References cited:
- JP-A- 08 026 881
- JP-A- 57 111 296
- JP-A- 63 156 091
- JP-A- 2001 261 481
- US-A- 4 888 242
- US-A1- 2003 148 104
- US-A1- 2005 196 613

## Description

### TECHNICAL FIELD

The present invention relates to a method of protecting a carbonaceous crucible, and a single-crystal pulling apparatus. More particularly, the invention relates to a method of protecting a carbonaceous crucible of a crucible apparatus having a quartz crucible and a carbonaceous crucible in which the quartz crucible is inserted, especially a single crystal pulling melting crucible apparatus, and a single-crystal pulling apparatus employing the protecting method.

### BACKGROUND ART

Conventionally, a crucible apparatus having a graphite crucible and a quartz crucible has been used typically as a single crystal pulling melting crucible apparatus. A typical single-crystal pulling apparatus in a semiconductor manufacturing process is a single-crystal pulling apparatus for a Czochralski process (the process is hereinafter referred to as a "CZ process," and the apparatus is referred to as a "CZ apparatus"). In this single-crystal pulling apparatus for the CZ process, a graphite crucible and a quartz crucible are directly in contact with each other. Therefore, the contact surface of the graphite crucible that is in contact with the quartz crucible turns into silicon carbide (hereinafter SiC) because of the reaction between the quartz crucible and the carbonaceous crucible, or the reaction with the SiO gas or the like that originates from Si, resulting in defects such as cracks, due to the difference in thermal expansion coefficient between SiC and graphite. In order to solve such a problem, it has been proposed that a protective sheet made of an expanded graphite material (hereinafter also referred simply to as an "expanded graphite sheet") is interposed between the quartz crucible and the graphite crucible so as to cover the inner surface of the graphite crucible, whereby breakage of the graphite crucible can be prevented to keep the life of the apparatus long (for example, see Patent Document 1).

[Patent Document 1] Japanese Patent No. 2528285

### DISCLOSURE OF THE INVENTION

### PROBLEMS TO BE SOLVED BY THE INVENTION

However, the expanded graphite sheet used as the foregoing conventional protective sheet is a one-piece sheet, so the following problem occurs when installing the sheet on the inner surface of the crucible.
(1) Since the inner surface of the graphite crucible has a curved surface shape, it is difficult to cover the graphite crucible inner surface with one piece of expanded graphite sheet without gaps.
(2) The expanded graphite sheet has the feature that it is weak in strength since it is made by compressing flocculent expanded graphite. For this reason, an expanded graphite sheet that is a one-piece sheet may be broken or bent when it is attempted to fit along the inner surface of the crucible. On the other hand, a long work hour is necessary when it is attempted to fit such a one-piece expanded graphite sheet along the inner surface of the graphite crucible without breaking the sheet.
(3) Moreover, the size of each one graphite sheet tends to become larger as the size of the crucible has become greater. As a consequence, the problems of the breakage of the expanded graphite sheet and the poor workability resulting in long work hours have become more serious.

Patent Document 1 discloses a one-piece expanded graphite sheet in which a cut is formed in the lower face (see Figs. 6 and 7 of Patent Document 1), but this is a one-piece protective sheet all the same, which has the same problems as described in the foregoing (1) to (3).

Document US 4,888,242 discloses a refractory heat-insulating graphite sheet material comprising an expanded graphite sheet having an impurity content of not higher than 100 ppm. The sheet material may be used for protecting the graphite material of a graphite crucible.

Document JP 57111296 A discloses a crucible device for melting a semiconductor. The crucible device comprises a quartz crucible and a graphite crucible with a thin flexible graphite part between the quartz crucible and the graphite crucible. With this configuration, the deformation damage of the quartz crucible and the graphite crucible caused by heating can be prevented and both crucibles may be used several times.

Patent document JP 08 026881 A discloses a device for pulling up a silicon single crystal and a container for pulling which is used therefore. The container for pulling up the silicon single crystal is rotatably supported in a chamber and silicon raw material is charged into the container, heated by a heater arranged outside the container and melted while thermally insulating the silicon single crystal by a heat insulating column set in the outer periphery of the heater. A seed crystal rotatably hung from above is immersed in the molten silicon and is pulled up and a cylinder made by bending a carbon fiber-reinforced carbon material sheet is inserted into at least the inner peripheral face of the heat insulating column.

Document JP 2001 261481 A discloses a sheet for protecting the inner surface of a carbonaceous crucible. A sheet-like carbon fiber processed good comprising a C/C material obtained by impregnating a resin into a sheet-like fiber processed good composed of carbon fibers and carbonising, or a sheet-like fiber processed good composed of carbon fibers and carbonising, or a sheet-like fiber processed good comprising a C/C obtained by impregnating and/or coating pyrolytic carbon onto the sheet-like carbon fiber processed good of carbon fibers, having an ash content of ≤ 50 ppm and capable of being bent in such a state that the radius of curvature is ≤ 50 mm is used as a material for the protecting sheet. The sheet-like carbon fiber processed good is processed in a prescribed shape and disposed along the inner surface of the carbonaceous crucible.

The present invention has been accomplished in view of the foregoing circumstances. It is an object of the invention to provide a method for protecting a carbonaceous crucible that remarkably lessens the work hours, is capable of covering the inner surface without breaking the sheet or without gaps, and is suitable for size increase of the crucible, and to provide a single-crystal pulling apparatus employing the method.

### MEANS FOR SOLVING THE PROBLEMS

In order to accomplish the foregoing object, the present invention provides a method of protecting a carbonaceous crucible, comprising: interposing a protective sheet made of an expanded graphite material between a quartz crucible and a carbonaceous crucible on which the quartz crucible is placed; and installing two or more protective sheet pieces on an inner surface of the carbonaceous crucible, each of the protective sheet pieces having a shape such that the sheet pieces are combined integrally to form the protective sheet in installing the protective sheet between the crucibles,
wherein:
each of the protective sheet pieces has securing means for securing the protective sheet pieces that are adjacent to each other in a condition in which the protective sheet pieces are installed on the inner surface of the carbonaceous crucible,
the securing means comprising a configuration in which a protruding portion is provided on an end part of one of the protective sheet pieces that are adjacent to each other while a recessed portion in which the protruding portion fits is provided in an end part of another protective sheet piece, so that the protective sheet can be installed by inserting the protruding portion into the recessed portion, or a configuration in which a cut is formed in an end of one of the protective sheet pieces, and another protective sheet piece is inserted into the cut.

Here, the term "carbonaceous crucible" is intended to mean a crucible including both a graphite crucible made of a graphite material and a crucible made of a carbon fiber-reinforced carbon composite material (what is called a C/C material, the crucible hereinafter referred to as a "C/C crucible"). Of course, the graphite crucible and the C/C crucible may be subjected to coating or impregnation with pyrocarbon or the like.

When installing two or more protective sheet pieces on the inner surface of the carbonaceous crucible, each having a shape such that they are combined integrally in installing the protective sheet pieces between the crucibles to form the protective sheet, the workability improves remarkably and the required work hour reduces significantly in comparison with when installing the one-piece protective sheet itself on the inner surface of the carbonaceous crucible. In particular, when a one-piece protective sheet is used for a large-sized crucible, the size becomes considerably large, and handling becomes difficult. Moreover, the installing work requires a long time because the sheet is installed so as to fit along the inner surface of the carbonaceous crucible without breaking the sheet. In contrast, when using a plurality of separate protective sheet pieces, handling is easy, and the work hour reduces. In addition, when the sheet is cut and split into dimensions and shapes such that the sheet pieces can be easily installed along the crucible inner surface in a curved surface shape, good shape-conforming capability is obtained, so the crucible inner surface can be covered without gaps. Furthermore, by splitting the sheet into a plurality of sheet pieces, the sheet can be transported separately in a desirable number. As a result, the transportation of the sheet is easier than when a one-piece sheet is transported.

The expanded graphite sheet shows high self-lubricating capability. Therefore, the protective sheet pieces may slip when they are installed on the inner surface of the carbonaceous crucible, causing misalignment. When each of the protective sheet pieces has securing means for securing adjacent protective sheet pieces to each other, misalignment does not easily occur. As a result, they can reliably cover the location in the crucible inner surface that tends to turn into SiC.

In the present invention, the protective sheet pieces that are adjacent to each other are installed in such a manner that substantially no gap forms in the inner surface of the carbonaceous crucible.

When the protective sheet pieces that are adjacent to each other are installed in such a manner that substantially no gap forms, it is possible to completely cover the location in the carbonaceous crucible inner surface that is likely to turn into SiC easily. This improves the prevention of turning into SiC of the carbonaceous crucible inner surface. Moreover, since the protective sheet pieces that are adjacent to each other are installed in such a manner that there is little overlap therebetween, it is possible to make the temperature distribution over the entire carbonaceous crucible uniform, preventing the carbonaceous crucible from cracks. The reason is that, when the protective sheet pieces that are adjacent to each other are installed with overlaps, temperature uneveness occurs in the overlapped portion, so a uniform temperature distribution does not form over the entire carbonaceous crucible. This may result in cracks when the carbonaceous crucible undergoes thermal expansion.

In the present invention, it is preferable that the carbonaceous crucible is a crucible made of a carbon fiber-reinforced carbon composite material (hereinafter referred to as a "C/C crucible").

In the case of the C/C crucible, SiO gas passes through the entirety of the crucible inner surface. Therefore, the protective sheet pieces are installed so as to cover the entirety of the inner surface of the carbonaceous crucible. Thereby, it is possible to prevent the C/C crucible from breaking and to prolong the life.

In addition, the present invention provides a single-crystal pulling apparatus comprising a carbonaceous crucible protected according to the above-described method. By applying this method to a pulling apparatus of a silicon single crystal or the like, it becomes possible to perform uniform heating and to manufacture a silicon single crystal that shows few crystal defects.

The present invention further provides a protective sheet for protecting a carbonaceous crucible made of an expanded graphite material to be interposed between a quartz crucible and a carbonaceous crucible on which the quartz crucible is placed, comprising two or more protective sheet pieces to be installed on an inner surface of the carbonaceous crucible, each of the protective sheet pieces having such a shape that the protective sheet pieces are combined integrally to form the protective sheet in installing the protective sheet between the crucibles, wherein:
each of the protective sheet pieces comprises securing means for securing the protective sheet pieces that are adjacent to each other in a condition in which the protective sheet pieces are installed on the inner surface of the carbonaceous crucible,
the securing means assembling the protective sheet pieces into a form protective toward the carbonaceous crucible by a configuration in which a protruding portion is provided on an end part of one of the protective sheet pieces that are adjacent to each other while a recessed portion in which the protruding portion fits is provided in an end part of another protective sheet piece, so that the protective sheet can be installed by inserting the protruding portion into the recessed portion, or by a configuration in which a cut is formed in an end of one of the protective sheet pieces, and another protective sheet piece is inserted into the cut.

### ADVANTAGES OF THE INVENTION

According to the present invention, when installing two or more protective sheet pieces on the inner surface of the carbonaceous crucible, each having a shape such that they are combined integrally in installing the protective sheet pieces between the crucibles to form the protective sheet, the workability improves remarkably and the required work hour reduces significantly in comparison with when installing the single sheet protective sheet itself on the inner surface of the carbonaceous crucible. In particular, when a single sheet protective sheet is used for a large-sized crucible, the size becomes considerably large, and handling becomes difficult. Moreover, the installing work requires a long time because the sheet is installed so as to fit along the inner surface of the carbonaceous crucible without breaking the sheet. In contrast, when using a plurality of separate protective sheet pieces, handling is easy, and the work hour reduces. In addition, when the sheet is cut and split into dimensions and shapes such that the sheet pieces can be easily installed along the crucible inner surface in a curved surface shape, good shape-conforming capability is obtained, so the crucible inner surface can be covered without gaps. Furthermore, by splitting the sheet into a plurality of sheet pieces, the sheet can be transported separately in a desirable number. As a result, the transportation of the sheet is easier than when a single piece sheet is transported.

### BEST MODE FOR CARRYING OUT THE INVENTION

Hereinbelow, the present invention will be described based on the preferred embodiments. It should be noted that the present invention is not limited to the following embodiments.

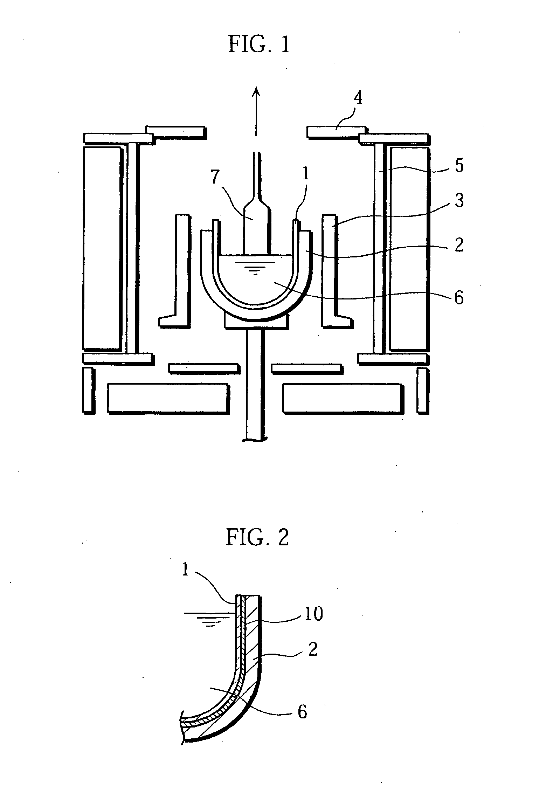

First, a schematic configuration of crucibles in the single-crystal pulling apparatus shown in Fig. 1 of the present invention will be described, and then, a method of protecting the inner surface of the carbonaceous crucible using the protective sheet according to the present invention will be described.

### (Configuration of Single-crystal Pulling Apparatus)

Fig. 1 is a cross-sectional view illustrating a primary portion of the single-crystal pulling apparatus. Fig. 2 is an enlarged cross-sectional view of the crucible.

As illustrated in Fig. 1, the CZ apparatus comprises a carbonaceous crucible 2 that supports a quartz crucible 1, a heater 3, an upper ring 4, an inner shield 5, and so forth. Thus, the CZ apparatus obtains a single crystal 7 by heating a source material in the quartz crucible 1 to a high temperature by the heater 3 disposed around the quartz crucible 1 to obtain a source material melt 6, and pulling the source material melt 6.

As illustrated in Fig. 1, the carbonaceous crucible 2 is directly in contact with the quartz crucible 1. For this reason, the surface of the carbonaceous crucible 2 that is in contact with the quartz crucible 1 turns into silicon carbide (hereinafter SiC), because of the reaction between the quartz crucible and the carbonaceous crucible, or the reaction with the SiO gas or the like that originates from Si, resulting in defects such as cracks, due to the difference in thermal expansion coefficient between SiC and graphite. In order to solve the just-mentioned problem, a protective sheet 10 made of an expanded graphite material according to the present invention is interposed between the quartz crucible 1 and the carbonaceous crucible 2, as illustrated in Fig. 2. The protective sheet 10 according to the present invention comprises a plurality of split protective sheet pieces. In other words, a protective sheet made of one sheet of expanded graphite material is split into a plurality of pieces, and the split protective sheet pieces are installed on the inner surface of the carbonaceous crucible 2 without gaps.

### (How Protective Sheet Pieces Are Laid)

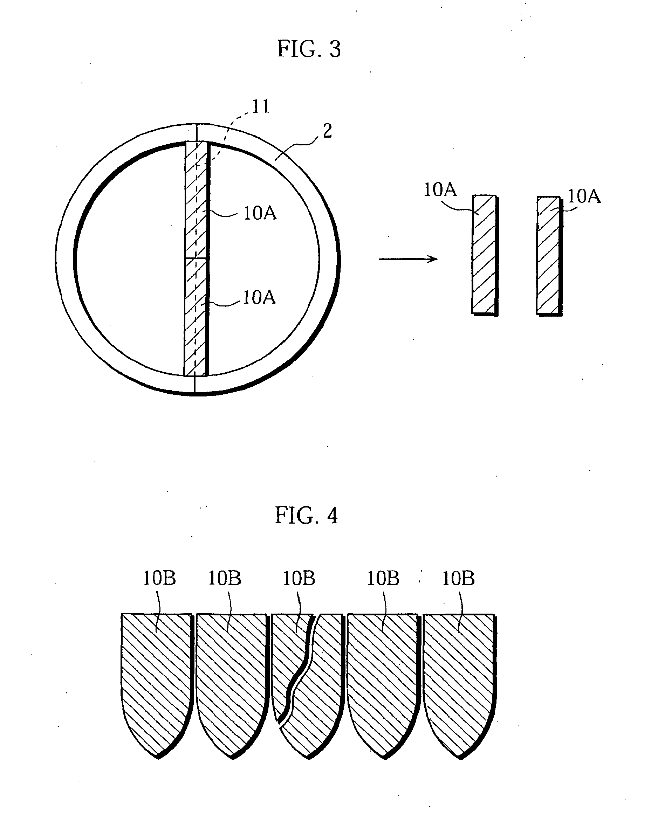

The types of the carbonaceous crucible 2 include a graphite crucible made of a graphite material, and a crucible formed of a carbon fiber-reinforced carbon composite material (C/C material: hereinafter, this crucible is referred to as a "C/C crucible"). In the case of the graphite crucible, separate crucible portions divided into, for example, two pieces or three pieces are butt jointed to form a crucible, considering the convenience in transportation. It is known that, from the butt joint portions (what is called divided surfaces), SiO gas passes through, so the butt joint portions selectively turn into SiC. In view of this, one piece of protective sheet formed into a strip is split into a plurality of strips, and the split protective sheet pieces 10A are installed along a butt joint portion 11, as illustrated in Fig. 3. Fig. 3 shows an example in which the sheet is split into two pieces, but it is possible to split the sheet into three or four pieces, for example. It is also possible to split the sheet into equal parts, but may be split into various sizes.

In the case of the C/C material crucible, it is preferable that the sheet be installed along the entire inner surface of the crucible. Accordingly, as illustrated in Fig. 4, one piece of protective sheet is split in such a manner that the upper portion is split into strips and the lower portion is split to have a curved surface shape that fits along a bottom portion of the spherical shape, and the split protective sheet pieces 10B are installed along the entire inner surface of the C/C material crucible. It should be noted that the way of splitting is not limited to this, but the sheep may be split into a spherical bottom portion of the spherical shape and an inner circumferential portion, and the inner circumferential portion is further split into a plurality of stripes.

When the protective sheet made of one piece of expanded graphite material is cut and split into predetermined shapes and dimensions and the split protective sheet pieces are installed on the inner surface of the carbonaceous crucible, the protective sheet pieces easily fit along the crucible inner surface in a curved surface shape. As a result, it is possible to cover the butt joint portion, which tends to turn into SiC easily, without gas in the case of the graphite crucible, and to cover the entire crucible inner surface in the case of the C/C material crucible. As a result, prevention of turning into SiC of the inner surface of the carbonaceous crucible 5 is improved.

Moreover, by using split protective sheet pieces, handling becomes easy and workability improves in comparison with when using one-piece protective sheet. Therefore, even when the size of the crucible increases, the protective sheet can be installed on the crucible inner surface without breaking the sheet or taking many work hours.

In addition, the expanded graphite sheet shows high self-lubricating capability. Therefore, the protective sheet pieces may slip when they are laid on the inner surface of the carbonaceous crucible, causing misalignment. In particular, when inserting the quartz crucible after the protective sheet pieces are installed on the carbonaceous crucible inner surface, the quartz crucible makes contact with the installed protective sheet pieces, and misalignment may occur, because the gap between the carbonaceous crucible and the quartz crucible is extremely small. In view of this, each of the protective sheet pieces may have a securing means such as to secure the protective sheet pieces that are adjacent to each other, so that misalignment does not occur in the protective sheet pieces that have been once installed at predetermined positions. An example of the securing means is a configuration in which a protruding portion is provided on an end part of one of the protective sheet pieces that are adjacent to each other while a recessed portion in which the protruding portion fits is provided in an end part of another protective sheet piece, so that the protective sheet can be installed by inserting the protruding portion into the recessed portion. Another example of the method may be a configuration in which a cut is formed in an end of one of the protective sheet pieces, and another protective sheet piece is inserted into the cut. Of course, other securing method may be used. In short, any method may be used as long as the protective sheet pieces that are adjacent to each other can be secured.

### (Manufacturing Method of Protective Sheet Piece)

The protective sheet pieces may be manufactured in the following manner. A one-piece expanded graphite sheet is a sheet-like material made from expanded graphite, and a typical example is as follows. First, natural or synthetic graphite flakes, kish graphite, or the like are treated with an oxidizing agent, to form an intercalation compound in the graphite particles. Next, this is heated to a high temperature, or preferably exposed abruptly to a high temperature to expand rapidly. This treatment causes graphite particles to expand in a direction perpendicular to the layer plane due to the gas pressure of an intercalation compound of the graphite particles, and the volume expands from about 100 times to 250 times. The oxidizing agent used in this case is one that forms an intercalation compound, such as a mixed acid of a sulfuric acid and a nitric acid, and a sulfuric acid to which an oxidizing agent such that a sodium nitride, a potassium permanganate, or the like is added.

Next, impurities are removed to an ash content of 50 ppm or less, preferably 30 ppm or less, and the expanded graphite is formed into a sheet shape by compressing or roll-forming, to prepare an expanded graphite sheet.

Next, the expanded graphite sheet manufactured in the just-described method are cut and split into predetermined dimensions and shapes, to prepare the protective sheet pieces.

### EXAMPLES

Hereinbelow, the present invention will be described in detail by examples. It should be noted that the present invention is in no way limited to the following examples.

### (Example 1)

Protective sheet pieces split into two pieces and prepared in the same manner as described in the foregoing embodiment (hereinafter referred to as a present invention sheet pieces A1) were installed along the butt joint portion of a graphite crucible that was identical to that described in the foregoing embodiment (a graphite crucible divided into two pieces) and that had a size of 22 inches, and an actual machine test for the CZ apparatus was conducted 50 times. The time required for installing the protective sheet pieces on the graphite crucible (work hour), the proportion of the protective sheet pieces that broke and became unable to use (defective rate), and the durability of the graphite crucible were determined by the test. The results are shown in Table 1.

**[TABLE 1]**

| Type of sheet (sheet piece) | Work hour (min.) | Defective rate (%) | Durability |
|---|---|---|---|
| Present invention sheet piece A1 | 5 | 0 | - |
| Present invention sheet piece A2 | 10 | 0 | - |
| Comparative sheet Z1 | 7 | 10 | Equivalent to A1 |
| Comparative sheet Z2 | 20 | 20 | Equivalent to A2 |

### (Example 2)

An actual machine test was conducted under the same conditions as those in Example 1, except that the size of the graphite crucible was 40 inches and that protective sheet pieces, which are split into two pieces, having a corresponding size (hereinafter referred to as a present invention sheet piece A2) were used, to determine the work hour, the defective rate, and the durability. The results are shown in Table 1.

### (Comparative Example 1)

An actual machine test was conducted under the same conditions as those in Example 1, except that one-piece strip-shaped protective sheet that is not split into two pieces (hereinafter referred to as a comparative sheet Z1) was used, to determine the work hour, the defective rate, and the durability. The results are shown in Table 1.

### (Comparative Example 2)

An actual machine test was conducted under the same conditions as those in Example 1, except that the size of the graphite crucible was 40 inches and that one-piece strip-shaped protective sheet (hereinafter referred to as a comparative sheet Z2) having a corresponding size to the crucible size was used, to determine the work hour, the defective rate, and the durability. The results are shown in Table 1.

### (Example 3)

Protective sheet pieces that were split in the same manner as described in the foregoing embodiment (hereinafter referred to as a present invention sheet pieces B1) were installed on the inner surface of a C/C crucible that was identical to that described in the foregoing embodiment and that had a size of 22 inches, so as to cover the entire inner surface of the C/C crucible, and an actual machine test for the CZ apparatus was conducted 50 times. The time required for installing the protective sheet pieces on the C/C crucible (work hour), the proportion of the protective sheet pieces that broke and became unable to use (defective rate), and the durability of the graphite crucible were determined by the test. The results are shown in Table 2.

**[TABLE 2]**

| Type of sheet (sheet piece) | Work hour (min.) | Defective rate (%) | Durability |
|---|---|---|---|
| Present invention sheet piece B1 | 10 | 0 | - |
| Present invention sheet piece B2 | 20 | 0 | - |
| Comparative sheet Y1 | 20 | 30 | Shorter than B1 |
| Comparative sheet Y2 | 40 | 50 | Shorter than B2 |

### (Example 4)

An actual machine test was conducted under the same conditions as those in Example 3, except that the size of the C/C crucible was 40 inches and that protective sheet pieces having a corresponding size and split (hereinafter referred to as a present invention sheet piece B2) were used, to determine the work hour, the defective rate, and the durability. The results are shown in Table 2.

### (Comparative Example 3)

An actual machine test was conducted under the same conditions as those in Example 3, except that one-piece protective sheet that is not split into two pieces (hereinafter referred to as a comparative sheet Y1) was used, to determine the work hour, the defective rate, and the durability. The results are shown in Table 2.

### (Comparative Example 4)

An actual machine test was conducted under the same conditions as those in Example 3, except that the size of the C/C crucible was 40 inches and that a one-piece protective sheet having a corresponding size (hereinafter referred to as a comparative sheet Y2) was used, to determine the work hour, the defective rate, and the durability. The results are shown in Table 2.

### (Analysis of the Test Results)

As clearly seen from Tables 1 and 2, the present invention sheet pieces A1, A2, B1, and B2 are better in durability than the comparative sheets Z1, Z2, Y1, and Y2, when judging the results comprehensively. It is also understood that the present invention sheet pieces A1, A2, B1, and B2 are far better in work hour and defective rate than the comparative sheets Z1, Z2, Y1, and Y2.

In particular, when comparing the defective rates between the 22-inch crucible and the 40-inche crucible, considerably higher defective rates are observed with the crucibles having a greater size, in the case of the comparative sheets Z1, Z2, Y1, and Y2. In contrast, it is demonstrated that, in the cases of the present invention sheet pieces A1, A2, B1, and B2, the defective rate stays at 0% even when the crucible size increases. Therefore, it is believed that the protecting method using the present invention sheet piece is suitable for large-sized crucibles.

### INDUSTRIAL APPLICABILITY

The present invention is suitable for a method of protecting a carbonaceous crucible in a single crystal pulling crucible apparatus according to a CZ method.

### BRIEF DESCRIPTION OF THE DRAWINGS

[Fig. 1] Fig. 1 is a cross-sectional view illustrating a primary portion of a single-crystal pulling apparatus.
[Fig. 2] Fig. 2 is an enlarged cross-sectional view of a crucible.
[Fig. 3] Fig. 3 is a view illustrating an embodiment of how protective sheet pieces are installed.
[Fig. 4] Fig. 4 is a view illustrating another embodiment of how protective sheet pieces are installed.

### DESCRIPTION OF REFERENCE NUMERALS

- 1:: quartz crucible
- 2:: carbonaceous crucible
- 3:: heater
- 4:: upper ring
- 5:: inner shield
- 6:: source material melt
- 7:: single crystal
- 10A, 10B:: protective sheet pieces
- 11:: butt joint portion

## Claims

1. A method of protecting a carbonaceous crucible by interposing a protective sheet made of an expanded graphite material between a quartz crucible and a carbonaceous crucible on which the quartz crucible is placed, comprising:
installing two or more protective sheet pieces on an inner surface of the carbonaceous crucible, each of the protective sheet pieces having such a shape that the protective sheet pieces are combined integrally to form the protective sheet in installing the protective sheet between the crucibles, wherein:
each of the protective sheet pieces has securing means for securing the protective sheet pieces that are adjacent to each other in a condition in which the protective sheet pieces are installed on the inner surface of the carbonaceous crucible,
the securing means comprising a configuration in which a protruding portion is provided on an end part of one of the protective sheet pieces that are adjacent to each other while a recessed portion in which the protruding portion fits is provided in an end part of another protective sheet piece, so that the protective sheet can be installed by inserting the protruding portion into the recessed portion, or a configuration in which a cut is formed in an end of one of the protective sheet pieces, and another protective sheet piece is inserted into the cut.

2. The method of protecting a carbonaceous crucible according to claim 1, wherein the protective sheet pieces that are adjacent to each other are installed in such a manner that substantially no gap forms therebetween in the inner surface of the carbonaceous crucible.

3. The method of protecting a carbonaceous crucible according to claim 1, wherein the carbonaceous crucible is a carbon fiber-reinforced carbon composite material, and the protective sheet pieces are installed so as to cover the entire inner surface of the carbonaceous crucible.

4. A single-crystal pulling apparatus comprising a carbonaceous crucible protected according to the method of claim 1.

5. A protective sheet for protecting carbonaceous crucible made of an expanded graphite material to be interposed between a quartz crucible and a carbonaceous crucible on which the quartz crucible is placed, comprising two or more protective sheet pieces to be installed on an inner surface of the carbonaceous crucible, each of the protective sheet pieces having such a shape that the protective sheet pieces are combined integrally to form the protective sheet in installing the protective sheet between the crucibles, wherein:
each of the protective sheet pieces comprises securing means for securing the protective sheet pieces that are adjacent to each other in a condition in which the protective sheet pieces are installed on the inner surface of the carbonaceous crucible,
the securing means assembling the protective sheet pieces into a form protective toward the carbonaceous crucible by a configuration in which a protruding portion is provided on an end part of one of the protective sheet pieces that are adjacent to each other while a recessed portion in which the protruding portion fits is provided in an end part of another protective sheet piece, so that the protective sheet can be installed by inserting the protruding portion into the recessed portion, or by a configuration in which a cut is formed in an end of one of the protective sheet pieces, and another protective sheet piece is inserted into the cut.

## Patentansprüche

1. Verfahren zum Schützen eines kohlenstoffhaltigen Tiegels durch Einfügen eines schützenden Bogens aus einem expandierten Graphitmaterial zwischen einen Quarztiegel und einen kohlenstoffhaltigen Tiegel, auf dem der Quarztiegel platziert ist, das Folgendes umfasst:
Installieren von zwei oder mehr Teilen des schützenden Bogens an einer inneren Oberfläche des kohlenstoffhaltigen Tiegels, wobei jedes der Teile des schützenden Bogens eine solche Form hat, dass die Stücke des schützenden Bogens integral zusammengesetzt werden, um den schützenden Bogen beim Installieren des schützenden Bogens zwischen den Tiegeln zu bilden, wobei:
jedes der Teile des schützenden Bogens Sicherungsmittel aufweist zum Sichern der zueinander benachbarten Teile des schützenden Bogens in einem Zustand, in dem die Teile des schützenden Bogens auf der inneren Oberfläche des kohlenstoffhaltigen Tiegels installiert sind,
die Sicherungsmittel eine Konfiguration, in der ein vorstehender Teil an einem Endteil eines der zueinander benachbarten Teile des schützenden Bogens bereitgestellt ist, wohingegen ein ausgesparter Teil, in den der vorstehende Teil passt, an einem Endteil eines anderen Teils des schützenden Bogens bereitgestellt ist, so dass der schützende Bogen durch Einfügen des vorstehenden Teils in den ausgesparten Teil installiert werden kann, oder eine Konfiguration, in der ein Schnitt in einem Ende eines der Teile des schützenden Bogens gebildet ist und ein anderes Teils des schützenden Bogens in den Schnitt eingeführt wird, umfassen.

2. Verfahren zum Schützen eines kohlenstoffhaltigen Tiegels nach Anspruch 1, wobei die zueinander benachbarten Teile des schützenden Bogens derart installiert werden, dass sich im Wesentlichen keine Lücke dazwischen auf der inneren Oberfläche des kohlenstoffhaltigen Tiegels bildet.

3. Verfahren zum Schützen eines kohlenstoffhaltigen Tiegels nach Anspruch 1, wobei der kohlenstoffhaltige Tiegel ein kohlefaserverstärktes Kohlenstoffverbundmaterial ist und die Teile des schützenden Bogens derart installiert sind, dass sie die gesamte innere Oberfläche des kohlenstoffhaltigen Tiegels bedecken.

4. Einkristallziehvorrichtung, die einen kohlenstoffhaltigen Tiegel umfasst, der nach dem Verfahren von Anspruch 1 geschützt ist.

5. Schützender Bogen aus einem expandierten Graphitmaterial zum Schützen eines kohlenstoffhaltige Tiegels, der zwischen einen Quarztiegel und einen kohlenstoffhaltigen Tiegel, auf dem der Quarztiegel platziert ist, einzufügen ist, der zwei oder mehr Teile des schützenden Bogens umfasst, die auf einer inneren Oberfläche des kohlenstoffhaltigen Tiegels zu installieren sind, wobei jedes der Teile des schützenden Bogens eine solche Form aufweist, dass die Teile des schützenden Bogens integral zusammengesetzt werden, um den schützenden Bogen beim Installieren des schützenden Bogens zwischen den Tiegeln zu bilden, wobei:
jedes der Teile des schützenden Bogens Sicherungsmittel umfasst zum Sichern der zueinander benachbarten Teile des schützenden Bogens in einem Zustand, in dem die Teile des schützenden Bogens auf der inneren Oberfläche des kohlenstoffhaltigen Tiegels installiert sind,
die Sicherungsmittel die Teile des schützenden Bogens in eine Form zusammenfügen, die schützend hinsichtlich des kohlenstoffhaltigen Tiegels ist, durch eine Konfiguration, in der ein vorstehender Teil an einem Endteil eines der zueinander benachbarten Teile des schützenden Bogens bereitgestellt ist, wohingegen eine ausgesparter Teil, in den der vorstehende Teil passt, an einem Endteil eines anderen Teils des schützenden Bogens bereitgestellt ist, so dass der schützende Bogen durch Einfügen des vorstehenden Teils in den ausgesparten Teil installiert werden kann, oder durch eine Konfiguration, in der ein Schnitt in einem Ende eines der Teile des schützenden Bogens gebildet ist und ein anderes Teils des schützenden Bogens in den Schnitt eingeführt wird.

## Revendications

1. Procédé de protection d'un creuset carboné en interposant une feuille de protection constituée d'un matériau à base de graphite expansé entre un creuset en quartz et un creuset carboné sur lequel le creuset en quartz est placé, comprenant :
l'installation de deux morceaux de feuille de protection ou plus sur une surface intérieure du creuset carboné, chacun des morceaux de feuille de protection ayant une forme telle que les morceaux de feuille de protection sont combinés intégralement pour former la feuille de protection lors de l'installation de la feuille de protection entre les creusets, dans lequel :
chacun des morceaux de feuille de protection comporte des moyens de fixation pour fixer les morceaux de feuille de protection qui sont adjacents les uns aux autres dans une condition dans laquelle les morceaux de feuille de protection sont installés sur la surface intérieure du creuset carboné,
les moyens de fixation présentant une configuration dans laquelle une partie saillante est prévue sur une partie d'extrémité de l'un des morceaux de feuille de protection qui sont adjacents les uns aux autres, tandis qu'une partie en retrait dans laquelle la partie saillante s'assemble est prévue dans une partie d'extrémité d'un autre morceau de feuille de protection, de sorte que la feuille de protection peut être installée en insérant la partie saillante dans la partie en retrait, ou une configuration dans laquelle une découpe est formée dans une extrémité de l'un des morceaux de feuille de protection, et un autre morceau de feuille de protection est inséré dans la découpe.

2. Procédé de protection d'un creuset carboné selon la revendication 1, dans lequel les morceaux de feuille de protection qui sont adjacents les uns aux autres sont installés d'une manière telle que sensiblement aucun espace ne se forme entre eux dans la surface intérieure du creuset carboné.

3. Procédé de protection d'un creuset carboné selon la revendication 1, dans lequel le creuset carboné est constitué d'un matériau composite à base de carbone renforcé par fibres de carbone, et les morceaux de feuille de protection sont installés de manière à recouvrir la surface intérieure entière du creuset carboné.

4. Appareil de tirage de monocristal comprenant un creuset carboné protégé selon le procédé de la revendication 1.

5. Feuille de protection pour protéger un creuset carboné constitué d'un matériau à base de graphite expansé à interposer entre un creuset en quartz et un creuset carboné sur lequel le creuset en quartz est placé, comprenant deux morceaux de feuille de protection ou plus à installer sur une surface intérieure du creuset carboné, chacun des morceaux de feuille de protection ayant une forme telle que les morceaux de feuille de protection sont combinés intégralement pour former la feuille de protection lors de l'installation de la feuille de protection entre les creusets, dans laquelle :
chacun des morceaux de feuille de protection comprend des moyens de fixation pour fixer les morceaux de feuille de protection qui sont adjacents les uns aux autres dans une condition dans laquelle les morceaux de feuille de protection sont installés sur la surface intérieure du creuset carboné,
les moyens de fixation assemblant les morceaux de feuille de protection en une forme protégeant le creuset carboné par une configuration dans laquelle une partie saillante est prévue sur une partie d'extrémité de l'un des morceaux de feuille de protection qui sont adjacents les uns aux autres, tandis qu'une partie en retrait dans laquelle la partie saillante s'assemble est prévue dans une partie d'extrémité d'un autre morceau de feuille de protection, de sorte que la feuille de protection peut être installée en insérant la partie saillante dans la partie en retrait, ou par une configuration dans laquelle une découpe est formée dans une extrémité de l'un des morceaux de feuille de protection, et un autre morceau de feuille de protection est inséré dans la découpe.
